# EUROPEAN PATENT APPLICATION

(11) **EP 1 760 442 A2**
(43) Date of publication of application: **07.03.2007**
(21) Application number: 06254103.2
(22) Date of filing: 04.08.2006
(51) Int. Cl.: G01L 9/06

(54) **Metal contact systems for semiconductor-based pressure sensors exposed to harsh chemical and thermal environments**

(30) Priority: 01.09.2005 US 217903
(71) Applicant: Sensata Technologies, Inc., Attleboro, MA 02703 (US)
(72) Inventor: Hadjiloucas, Costas, North Attleboro, MA 02760 (US); Mulligan, Sean P., South Boston, MA 02127 (US); Corkum, David L., Attleboro, MA 02703 (US); Hopkins, Alfred G., Attleboro Falls, MA 02763 (US)
(74) Representative: Legg, Cyrus James Grahame

(57) **Abstract**

Highly corrosion resistant electrically conductive contact systems suitable for semiconductor pressure sensor devices exposed to acidic, elevated temperature environments, such as automotive exhaust gas environments, are disclosed. The preferred embodiment (10) comprises a platinum top layer (26), and a tantalum lower layer (24). Both are highly electrically conductive layers and exhibit corrosion resistance to acidic environments. The top layer of the metallization also provides a suitable material for the external connectivity (e.g., wire bonding, solder bumping, chip-chip fusion). The lower layer of the metallization also serves as an adhesion layer between the top metal and lower layers, typically silicon based glasses and in some cases serves as a diffusion barrier.

## Description

### Field of the Invention

This invention relates generally to semiconductor pressure sensor devices and more particularly to the provision of contact systems for such devices that are suitable for exposure to harsh chemical and thermal environments.

### Background of the Invention

Semiconductor devices, such as semiconductor based pressure sensors, have been used in harsh environments such as in the acidic automotive exhaust gas environment. In the case of piezoresistive pressure sensors, electrically conductive metallization has been utilized to enable electrical connection from the sensor housing, typically by means of wire bond connections, to the ohmic contact of the sensor which is electrically connected via doped silicon to the piezoresistive portion of the pressure sensor.

The use of semiconductor-based pressure sensors in harsh environments is often limited by the susceptibility of the commonly used aluminum based metallization to corrosion that can occur in acidic environments. Various approaches have been taken to deal with this problem. One approach is shown in U.S. Patent No. 6,651,508, in which the sensor and wire bonds are covered with gel in an effort to protect the sensor from corrosion. However, the gel is permeable to acids and moisture, therefore, if the metallization system is not inherently robust to the media to which it is exposed, the sensor will eventually fail due to corrosion.

The challenges related to metal corrosion of semiconductor-based pressure sensor exposed to harsh environments are discussed in U.S. Patent Nos. 6,584,853; 6,030,684 and 6,085,596 which, unlike the present invention, do not disclose electrically conductive and corrosion resistant metal contact systems. Instead, these patents disclose various sensor coating and packaging techniques for protecting the underlying metallization resulting in larger and/or more expensive semiconductor sensors than desired. For instance, the electrically insulating layer used in'596 does not cover the aluminum bond pads which forces packaging schemes (see Fig. 3 and Fig. 4 of '596) that demand larger and consequently more expensive semiconductor pressure sensors.

U.S. Patent No. 6,107,170 discloses a gold, titanium-tungsten metallization to address the aluminum metallization corrosion problem. However, the titanium-tungsten layer is subject to corrosion when exposed to certain exhaust gas environments through imperfections in the gold layer and at exposed edges of the titanium-tungsten layer.

### Summary of the Invention

An object of the present invention is the provision of a corrosion resistant electrical contact system for semiconductor pressure sensors free of the prior art limitations noted above. Another object is the provision of a corrosion resistant, low cost electrical contact system for use with semiconductor-based pressure sensors suitable for exposure to harsh acidic and thermal environments. Yet another object of the invention is the provision of a low cost electrical contact system for semiconductor-type pressure sensors suitable for use in an automotive exhaust system.

In accordance with the teachings of the present invention, a semiconductor substrate, doped with impurities to make it suitable for piezoresistive pressure-sensing and formed typically with glass passivation layers, is patterned to expose regions of the doped semiconductor for the placement of metal electrical contacts. A suitable ohmic contact layer, such as platinum silicide or tantalum silicide, is formed in the exposed region of the doped semiconductor and a layer of tantalum is deposited over the ohmic contact layer and typically also over the passivation layers using any suitable method to form a dense film. The corrosion resistance of tantalum is exceptional. Unlike aluminum and titanium-tungsten, tantalum is virtually inert to all acids below 150 degrees C, with the exception of hydrofluoric acid which is not a concern in most applications. In most cases, it is preferred to add one or more layers of corrosion resistant material such as platinum or other precious metals, such as gold, palladium, iridium, rhodium or ruthenium, that are more conducive than tantalum to conventional electrical connection techniques, such as wire bonding, for connecting the semiconductor pressure sensor to a sensor package.

### Brief Description of the Drawings

Other objects, advantages and details of the electrical contact systems appear in the following detailed description of preferred embodiments of the invention, the detailed description referring to the drawings in which:
Fig. 1 is a cut away, cross sectional, elevational view of a semiconductor-based pressure sensor showing an electrical contact system made in accordance with the invention, and
Fig. 2 is a cross sectional, elevational view of a pressure sensor package incorporating the Fig. 1 sensor with the sensor wire bonded to the package.

Reference made to upper, lower and the like layers throughout the specification and claims refer to the orientation of layers shown in the drawings.

### Detailed Description of Preferred Embodiments

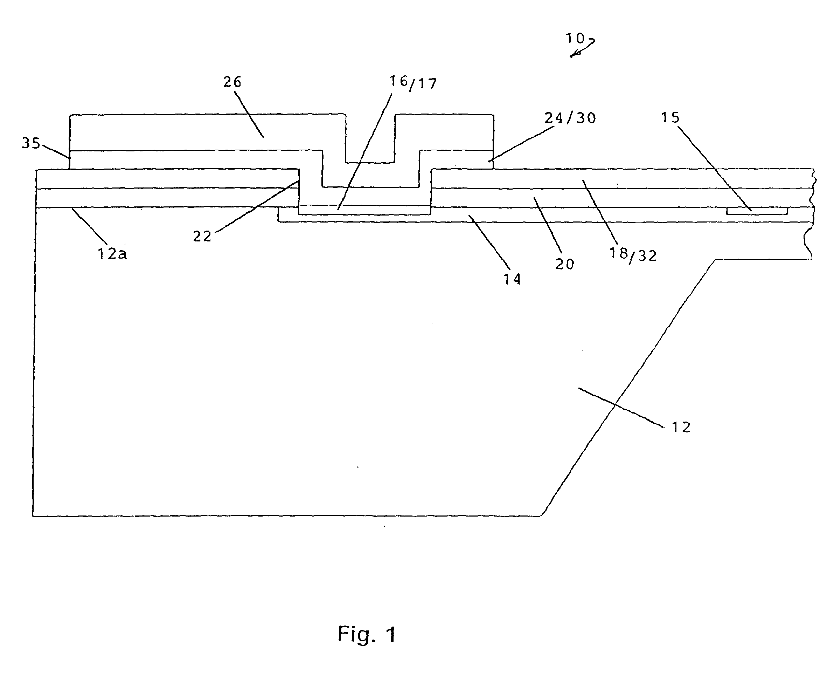

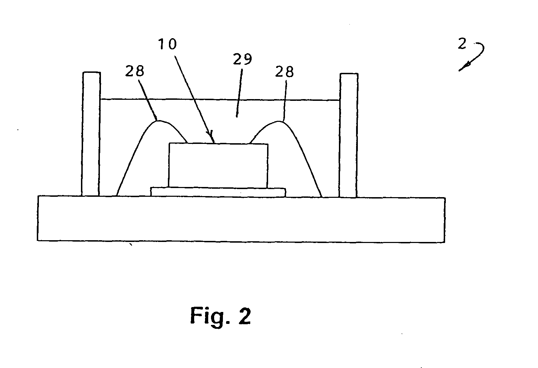

With reference to Fig. 1, a view of the semiconductor-type piezoresistive pressure sensor 10, cut away through the diaphragm portion of the sensor, is shown comprising a semiconductor substrate 12 of silicon having an impurity doped region 14 forming a conductive lead on the top surface 12a of the substrate. For the case of piezoresistive pressure sensors, piezoresistor 15 is shown at a portion of the conductive lead. Suitable passivation layers, for example silicon nitride 18 over silicon dioxide 20, or silicon carbide 32 over silicon dioxide 20, are applied on top surface 12a and an opening (via) 22 is then formed in passivation layers 18/32, 20. A corrosion resistant ohmic contact layer, for example, platinum silicide 16, or tantalum silicide 17, is formed in opening 22 with conventional semiconductor processes. A dense layer of tantalum 24 is then formed on the ohmic contact 16/17 extending up the sides of opening 22 onto the upper surface of passivation layer 18/32. Unlike aluminum and titanium-tungsten, tantalum is virtually inert to all acids below 150 degrees C, with the exception of hydrofluoric acid. However, exposure to hydrofluoric acid is not a concern in most applications and this sensitivity to hydrofluoric acid allows, in some cases, for cost effective wet chemical etching during manufacture of the sensor. It is important that the tantalum layer is robust to corrosion because corrosion at exposed edges 35 needs to be prevented and because further top layers, if any, can not be relied on for protection because of imperfections in these layers. Some examples of imperfections are pin holes, scratches and possible damage occasioned during assembly that could lead to corrosion. For instance, U.S. Patent No. 6,584,853, describes how, during wire bonding, tiny cracks can be formed on the conductive pads and that they could lead to corrosion. Although sensor 10 can be used with the tantalum layer 24 as the outermost layer, that is, it does not need to be covered by corrosion resistant metals for protection against chemical attack, it is generally preferable to add a layer 26 of material more conducive to wire bonding, such as a platinum layer or the like, to facilitate the electrical connection of the semiconductor sensor to other components of sensor package 2, as shown in Fig. 2 by wire bonds 28 and covered with gel 29.

Tantalum is an element of Group V B of the periodic table. As reported in "Tantalum as a material of construction for the chemical and processing industry - A critical survey" by U. Gramberg, M. Renner and H. Diekmann, Materials and Corrosion 46, pages 691, 692 (1995), "due to their electronic configuration, metals of this Group and the neighboring Group IV and VI B are strongly electronegative, therefore called 'reactive' metals....On the other hand, high reactivity also leads to the formation of extremely stable oxide at ambient temperatures as well, thus providing a necessary prerequisite for general chemical inertness. However, to protect the metal, the oxide layer has to bond strongly to the metal, be free of defects, be very thin in order to cause only a low level of internal stresses, and form spontaneously in case of damage. All conditions are fulfilled by tantalum and its oxide Ta2O5, resulting in the interesting phenomenon of a highly reactive metal possessing an extreme chemical inertness."

The tantalum layer 24 could, if desired, be replaced with a layer of niobium 30. Niobium, like tantalum, is an element of Group V B; its physical and chemical properties resemble those of tantalum and it is nearly as corrosion resistant as tantalum.

Precious, corrosion resistant metals, such as platinum and gold, typically do not adhere well to the passivation layers, hence the advantage provided by the tantalum layer which serves as an adhesion layer between the precious metals and the passivation layers. Tantalum adheres well to silicon glass layers such as silicon nitride and silicon dioxide. It should also be noted that the tantalum layer can also serve as a diffusion barrier, for example, to gold.

The superior chemical robustness of the platinum tantalum metallization to harsh acidic environments was demonstrated by several tests. For example, in one test, piezoresistive pressure sensors with aluminum metallization, piezoresistive pressure sensors with gold titanium-tungsten metallization, and piezoresistive pressure sensors with platinum tantalum metallization were coated with Sifel 8070, a gel manufactured by Shin-Etsu, and immersed at 80 degrees C in a 10.11M hydrochloric acid solution. Aluminum sensors were removed from the solution after 2 hours and SEM analysis showed extensive corrosion of the aluminum metallization. Gold titanium-tungsten sensors and platinum tantalum sensors were removed form the solution after 120 hours and SEM analysis showed extensive corrosion of the gold and titanium-tungsten layers but no sign of corrosion of the platinum tantalum metallization.

In another test, piezoresistive pressure sensors with aluminum metallization, piezoresistive pressure sensors with gold titanium-tungsten metallization and piezoresistive pressure sensors with platinum tantalum metallization were immersed, at 80 degrees C, in a solution of 5.02M sulfuric acid and 4.97M nitric acid. Aluminum sensors were removed from the solution after 90 minutes and SEM analysis showed extensive corrosion of the aluminum metallization. Gold titanium-tungsten sensors and platinum tantalum sensors were removed from the solution after 16 hours and SEM analysis showed extensive corrosion of the gold titanium-tungsten metallization and no sign of corrosion of the platinum tantalum metallization.

Metallization of a platinum tantalum contact system can be fabricated with conventional semiconductor processes. By way of example, starting with a semiconductor substrate:
pattern the passivation layers (e.g., silicon nitride over silicon dioxide) to expose vias for metal contacts,
form ohmic contacts in the vias; e.g., form platinum silicide by sputtering platinum, heat treating it to form platinum silicide and removing platinum from unwanted areas (e.g., by ion beam milling)
deposit a layer of tantalum by sputtering (or other deposition procedures that yield a dense film) approximately 500 angstroms thick and then deposit in-situ, to prevent oxidation of the tantalum, a layer of platinum of approximately 4000 angstroms thick
pattern the platinum tantalum metal layer with conventional photolithography processes (spin photo-resist, cure it, expose it to UV light and develop it)
remove Pt and Ta layers from unwanted areas (e.g., by ion beam milling or reactive ion etching)
dissolve the photo resist (metal etch mask).

Although the present invention has been described and illustrated through several preferred embodiments thereof, it is to be understood that the invention is not to be so limited since changes and modifications may be made therein which are within the intended scope of the invention as hereinafter claimed. For example, the tantalum layer 24 or niobium layer 30 could, if desired, be replaced by a layer of tantalum alloy or niobium alloy respectively. Also, the top platinum layer 26 could, if desired, be replaced or augmented with one or more layers of the following precious metals or alloys of these metals: gold, iridium, palladium, ruthenium or rhodium. Furthermore, instead of silicides, a sufficiently highly doped surface region of the semiconductor substrate could be utilized to achieve good ohmic contact.

Although the present invention has been described for use in a piezoresistive pressure sensor, the benefits of the disclosed metallization systems have obvious applications in other semiconductor-based pressure sensing technologies such as capacitive.

## Claims

1. A metal electrical contact system for a piezoresistive pressure sensor for use in harsh chemical and thermal environments comprising:
a semiconductor substrate, an electrically conductive impurity doped region formed in a portion of the substrate, a passivation layer formed on the said surface of the substrate including the impurity doped region, an opening formed in the passivation layer exposing a portion of the impurity doped region, an ohmic contact formed in a portion of the impurity doped region aligned with the opening, and a layer of one of tantalum and a tantalum alloy formed in the opening on the ohmic contact.

2. A metal electrical contact system according to claim 1 in which the said layer of one of tantalum and a tantalum alloy extends over the sides of the opening and onto the passivation layer.

3. A metal electrical contact system according to claim 1 further comprising a layer of precious metal on the said layer of one of the tantalum and a tantalum alloy.

4. A metal electrical contact system according to claim 3 in which the precious metal is platinum.

5. A metal electrical contact system according to claim 3 in which the precious metal is selected from the group consisting of platinum, gold, iridium, palladium, ruthenium, rhodium and alloys thereof.

6. A metal electrical contact system according to claim 1 in which the said layer of one of tantalum and a tantalum alloy is approximately 500 angstroms thick.

7. A metal electrical contact system according to claim 4 in which the platinum is approximately 4,000 angstroms thick.

8. A metal electrical contact system according to claim 1 in which the ohmic contact is platinum silicide.

9. A metal electrical contact system according to claim 1 in which the ohmic contact is tantalum silicide.

10. A metal electrical contact system according to claim 1 further comprising piezoresistive elements formed on the semiconductor substrate and electrically interconnected to the impurity doped region.

11. A metal electrical contact system for a semicoductor pressure sensor for use in harsh chemical and thermal environments comprising:
a semiconductor substrate, an electrically conductive impurity doped region formed in a portion of the substrate, a passivation layer formed on the said surface of the substrate including the impurity doped region, an opening formed in the passivation layer exposing a portion of the impurity doped region, an ohmic contact formed in at least a portion of the impurity doped region aligned with the opening, and a layer of one of niobium and a niobium alloy formed in the opening on the ohmic contact.

12. A metal electrical contact system according to claim 11 in which the said layer of one of niobium and a niobium alloy extends over the sides of the opening and onto the passivation layer.

13. A metal electrical contact system according to claim 11 further comprising a layer of precious metal on the said layer of one of the niobium and a niobium alloy.

14. A metal electrical contact system according to claim 13 in which the precious metal is platinum.

15. A metal electrical contact system according to claim 13 in which the precious metal is selected from the group consisting of platinum, gold, iridium, palladium, ruthenium, rhodium and alloys thereof

16. A metal electrical contact system according to claim 11 in which the said layer of one of niobium and a niobium alloy is approximately 500 angstroms thick.

17. A metal electrical contact system according to claim 14 in which the platinum is approximately 4,000 angstroms thick.

18. A metal electrical contact system according to claim 11 in which the ohmic contact is platinum silicide.

19. A metal electrical contact system according to claim 11 in which the ohmic contact is tantalum silicide.

20. A metal electrical contact system according to claim 11 further comprising piezoresistive elements formed on the semiconductor substrate and electrically interconnected to the impurity doped region.
